# EUROPEAN PATENT APPLICATION

(11) **EP 4 528 231 A1**
(43) Date of publication of application: **26.03.2025**
(21) Application number: 23199017.7
(22) Date of filing: 22.09.2023
(51) Int. Cl.: G01D 21/00

(54) **PORTABLE MEASUREMENT APPLICATION DEVICE, MEASUREMENT APPLI-CATION SERVER, MEASUREMENT APPLICATION, METHOD, AND COMPUTER PROGRAM PRODUCT**

(71) Applicant: Rohde & Schwarz GmbH & Co. KG, 81671 München (DE)
(72) Inventor: WONG, Kok Meng, 538688 Singapore (SG); WONG, Chun Soong, 528720 Singapore (SG)
(74) Representative: Kehl, Ascherl, Liebhoff & Ettmayr Patentanwälte Partnerschaft mbB

(57) **Abstract**

The present disclosure provides a portable measurement application device comprising at least one measurement port configured to acquire an analog measurement signal, an analog-to-digital converter for every measurement port, wherein the analog-to-digital converter is configured to convert the analog measurement signal acquired by the respective measurement port into a digital measurement signal, and a portable device communication interface coupled to each analog-to-digital converter, and configured to output the digital measurement signal of each analog-to-digital converter to a measurement application server. The disclosure further provides a measurement application server, a measurement application, a method, and a computer program product.

## Description

### TECHNICAL FIELD

The disclosure relates to a portable measurement application device. The disclosure further relates to a measurement application server, a measurement application, a method, and a computer program product.

### BACKGROUND

Although applicable to any type of measurement application, the present disclosure will mainly be described in conjunction with measurement applications that require portable measurement application devices.

Modern measurement application devices comprise a large number of electric and electronic components. Consequently, modern measurement application devices are very complex electronic devices. Especially, the digital signal processing components of such modern measurement application devices may be very sophisticated and may provide high processing power.

However, such digital signal processing components will be unused while the measurement application device is not used, while at the same time significantly increasing the production complexity and costs of the respective measurement application device.

Accordingly, there is a need for simplifying the structure of measurement application devices.

### SUMMARY

The above stated problem is solved by the features of the independent claims. It is understood, that independent claims of a claim category may be formed in analogy to the dependent claims of another claim category.

Accordingly, it is provided:

A portable measurement application device comprising at least one measurement port configured to acquire an analog measurement signal, an analog-to-digital converter for every measurement port, wherein the analog-to-digital converter is configured to convert the analog measurement signal acquired by the respective measurement port into a digital measurement signal, and a portable device communication interface coupled to each analog-to-digital converter, and configured to output the digital measurement signal of each analog-to-digital converter to a measurement application server.

Further, it is provided:

A measurement application server comprising a server communication interface configured to receive at least one digital measurement signal from at least one portable measurement application device, a triggering unit coupled to the server communication interface, wherein the triggering unit is configured to detect triggering events in the received at least one digital measurement signal, and a data acquisition unit coupled to the server communication interface, and to the triggering unit, wherein the data acquisition unit is configured to store the at least one digital measurement signal based on the triggering events detected by the triggering unit.

Further, it is provided:

A measurement application comprising at least one portable measurement application device according to the present disclosure, and a measurement application server according to the present disclosure.

Further, it is provided:

A computer implemented method for operating a measurement application, the method comprising acquiring at least one analog measurement signal in a portable measurement application device, converting the at least one analog measurement signal into at least one respective digital measurement signal in the portable measurement application device, outputting the at least one digital measurement signal to a measurement application server, detecting triggering events in the at least one digital measurement signal in the measurement application server, and storing the at least one digital measurement signal based on the detected triggering events in the measurement application server or a data storage outside of the measurement application server.

Further, it is provided:

A computer program product comprising computer readable instructions that when executed by a processor cause the processor to perform the function of the measurement application server according to the present disclosure, or that when executed by a processor cause the processor to perform the method according to the present disclosure.

The present disclosure is based on the finding, that at least some of the functions of a measurement application device not necessarily need to be performed directly in the respective measurement application device that acquires a signal to be measured.

Of course, acquiring measurement signals inevitably needs to be performed directly at the respective device under test, DUT. Further processing the signals, however, not necessarily needs to be performed directly in the respective measurement application device. Instead, such further signal processing may also be performed remotely to the respective measurement application device.

The present disclosure, therefore, provides a portable measurement application device. The portable measurement application device comprises only those elements that are required to acquire and transmit a signal to be measured. The further signal processing elements that are usually provided in measurement application devices, like oscilloscopes, according to the present disclosure are provided in a respective measurement application server.

A data communication link may be established between the portable measurement application device, and the measurement application server in a measurement application according to the present disclosure.

The portable measurement application device comprises at least one measurement port. Each measurement port may acquire a respective analog measurement signal that is to be measured in a measurement application. The measurement ports may comprise a hardware interface. In embodiments with a fully integrated or handheld portable measurement application device, the measurement port or measurement ports may each be provided with a probe tip for contacting the device under test. In other embodiments, a coaxial-type connector may be provided for each one of the measurement ports.

Internally, an analog-to-digital converter is provided for each measurement port. A multi-channel analog-to-digital converter may be used for multiple measurement ports. The analog-to-digital converter in each case converts the acquired analog measurement signal into a digital measurement signal.

After converting the analog measurement signals into digital measurement signals, the digital measurement signals are provided to a portable device communication interface that is coupled to the analog-to-digital converters. The portable device communication interface transmits the digital measurement signals to a respective measurement application server.

Although not explicitly shown, the portable measurement application device may further comprise a processor or processing element for controlling the single elements of the portable measurement application device, and for interacting with a user e.g., via switches, and knobs. A display may also be coupled to such a processor for user interaction. The processor may comprise or may be provided in or as part of at least one of a dedicated processing element e.g., a processing unit, a microcontroller, a field programmable gate array, FPGA, a complex programmable logic device, CPLD, an application specific integrated circuit, ASIC, or the like. A respective program or configuration may be provided to implement the required functionality. The processor may at least in part also be provided as a computer program product comprising computer readable instructions that may be executed by a processing element. In a further embodiment, the processor may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them. In addition, it is understood, that any required supporting or additional hardware may be provided like e.g., a power supply circuitry and clock generation circuitry.

The portable measurement application device according to the present disclosure, as is e.g., explained above, comprises only the minimum number of elements that are required to allow transmission of the acquired signals to be measured as digital measurement signals to the measurement application server. Therefore, complexity, production efforts, and costs may be significantly reduced for that element of a measurement application that a user has to acquire.

Generally, a measurement application device according to the present disclosure may comprise any device that may be used in a measurement application to acquire an input signal or to generate an output signal, or to perform additional or supporting functions in a measurement application. A measurement application device may also comprise or be implemented as program application or program applications, also called measurement program application or measurement program applications, that may be executed on a computer device and that may communicate with other measurement application devices in order to perform a measurement task. A measurement application, also called measurement setup, may e.g., comprise at least one or multiple different measurement application devices for performing electric, magnetic, or electromagnetic measurements, especially on single devices under test. Such electric, magnetic, or electromagnetic measurements may e.g., be performed in a measurement laboratory or in a production facility in the respective production line. An exemplary measurement application or measurement setup may serve to qualify the single devices under test i.e., to determine the proper electrical operation of the respective devices under test.

Measurement application devices to this end may comprise at least one signal acquisition section for acquiring electric, magnetic, or electromagnetic signals to be measured from a device under test, or at least one signal generation section for generating electric, magnetic, or electromagnetic signals that may be provided to the device under test. Such a signal acquisition section may comprise, but is not limited to, a front-end for acquiring, filtering, and attenuating or amplifying electrical signals. The signal generation section may comprise, but is not limited to, respective signal generators, amplifiers, and filters. In embodiments, the signal acquisition is performed via the signal acquisition section in a wired or contact-based manner or fashion. To this end, a respective measurement probe may be coupled to the measurement application device via a respective cable. In embodiments, the signal generation and the signal emission are performed via the signal generation section in a wired or contact-based manner or fashion. To this end, a respective signal output probe may be coupled to the measurement application device via a respective cable, or the signal may be output directly via the cable e.g., to a device under test.

Further, when acquiring signals, measurement application devices may comprise a signal processing section that may process the acquired signals. Processing may comprise converting the acquired signals from analog to digital signals, and any other type of digital signal processing, for example, converting signals from the time-domain into the frequency-domain.

The measurement application devices may also comprise a user interface to display the acquired signals to a user and allow a user to control the measurement application devices. Of course, a housing may be provided that comprises the elements of the measurement application device. It is understood, that further elements, like power supply circuitry, and communication interfaces may be provided.

A measurement application device may be a stand-alone device that may be operated without any further element in a measurement application to perform tests on a device under test. Of course, communication capabilities may also be provided for the measurement application device to interact with other measurement application devices.

A measurement application device may comprise, for example, a signal acquisition device e.g., an oscilloscope, especially a digital oscilloscope, a spectrum analyzer, or a vector network analyzer. Such a measurement application device may also comprise a signal generation device e.g., a signal generator, especially an arbitrary signal generator, also called arbitrary waveform generator, or a vector signal generator. Further possible measurement application devices comprise devices like calibration standards, or measurement probe tips.

Of course, at least some of the possible functions, like signal acquisition and signal generation, may be combined in a single measurement application device.

The measurement application server according to the present disclosure comprises a server communication interface that receives at least one digital measurement signal from at least one portable measurement application device. In embodiments, a single measurement application server may at least one of receive multiple digital measurement signals from a single measurement application server, and receive digital measurement signals from different portable measurement application devices.

In the measurement application server, the received at least one digital measurement signal is provided to a triggering unit that is coupled to the server communication interface. The triggering unit may comprise a digital triggering unit, as it is used in conventional measurement application devices, like oscilloscopes.

The triggering unit may be configured to trigger upon detection of specific triggering events in the received at least one digital measurement signal. A triggering event may comprise, but is not limited to, at least one of an edge trigger event that triggers on specified slope, positive, negative or either, and a specific signal level, a glitch triggering event that triggers on glitches of positive, negative or either polarity that are shorter or longer than a specified width, a width trigger event that triggers on a positive or negative pulse of a specified width, wherein the width can be shorter, longer, inside or outside the interval, a pattern trigger event that triggers when a logical combination (and, nand, or, nor) of the input channels stays true for a period of time shorter, longer, inside or outside a specified range, and a state trigger event that triggers when a logical combination (and, nand, or, nor) of the input channels stays true at a slope (positive, negative or either) in one selected channel, wherein state values may be high (H), low (L) or don't care (X). Other types of triggering events may e.g., comprise a Data2Clock trigger event, a serial pattern trigger event, a timeout trigger event, an interval trigger event, and a protocol trigger event.

In the measurement application server, a data acquisition unit is coupled to the server communication interface, and the triggering unit. In embodiments, the triggering unit may be coupled to the server communication interface indirectly via the data acquisition unit. The data acquisition unit stores the at least one digital measurement signal based on triggering events that are detected in the digital measurement signal by the triggering unit.

The data acquisition unit may e.g., be configured to store the digital measurement signal for a specific amount of time, after a triggering event is detected. The data acquisition unit may also be configured to store the digital measurement signal for a specific amount of time prior to the triggering event being detected, and for a specific amount of time after the triggering event is detected.

The measurement application server completes the portable measurement application device to provide all elements that are usually provided in a fully equipped measurement application device. At the same time, a single measurement application server may be provided for a plurality of portable measurement application devices at the same time. Therefore, with the teaching of the present disclosure, the complex functionality of the measurement application server may be provided only once, or centrally in a measurement application according to the present disclosure, instead of multiple times in each measurement application device.

The measurement application server may be a dedicated server that may be implemented as a single hardware device. The measurement application server may also be implemented as a distributed system comprising a plurality of servers, optionally with a load balancer, that distributes the load over the servers. The measurement application server may also be provided as a so-called cloud or cloud-server system that implements the server via virtualization methods independently of the underlying hardware.

With the present disclosure, a user may access the measurement data e.g., the stored digital measurement signals, via an interface to the server. A user may be provided with access to the measurement application server via a web-based interface that may be shown to the user via a browser application that is executed on a computing device, or via a native application that is directly executed on the computing device. The measurement application server may execute a respective computer program product that when executed by a processing element of the measurement application server causes the measurement application server to provide an API e.g., at least one of a REST-based API, a SOAP-based API, an XML-based API, and a JSON-based API.

The communication between the portable measurement application device, and the measurement application server may be performed via any adequate data link. The data output interface, and the server communication interface may comprise any kind of wired and wireless communication interfaces, like for example a network communication interface, especially an Ethernet, wireless LAN or WIFI interface, a USB interface, a Bluetooth interface, an NFC interface, a visible or non-visible light-based interface, especially an infrared interface.

It is further understood, that the portable measurement application device, and the measurement application server may communicate via an intermediary network with each other, and that such a network may comprise any type of network devices, like switches, hubs, routers, firewalls, and different types of network technologies.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to the portable measurement application device can be combined in all variations with each other and the disclosure of the description is not limited to the claim dependencies as specified in the claim set. Further, the features of the other independent claims may be combined with any of the features of the dependent claims relating to the portable measurement application device in all variations, wherein respective method steps perform the function of the respective apparatus elements.

In an embodiment, which can be combined with all other embodiments of the portable measurement application device mentioned above or below, the portable measurement application device may further comprise an analog signal processing section for each measurement port that is coupled between the respective measurement port and the respective analog-to-digital converter.

The analog signal processing section is also called "vertical system" in known measurement application devices. The analog signal processing section serves for modifying the analog measurement signal prior to converting the analog measurement signal into the digital measurement signal with the analog-to-digital converter.

The analog signal processing section may comprise elements like, amplifiers, attenuators, filters, and offset modifiers, that allow amplifying, attenuating, and moving the analog measurement signal. Since such operations usually modify the amplitude of a signal in the time domain, the analog signal processing section is usually called the vertical section.

The analog signal processing section may be configured e.g., manually by a user via at least one of switches, knobs, and a touchscreen of the portable measurement application device.

In an embodiment, which can be combined with all other embodiments of the portable measurement application device mentioned above or below, the portable device communication interface may further be configured to receive configuration data from the measurement application server, and to forward the configuration data to the analog signal processing section for configuring the analog signal processing section.

In embodiments, the analog signal processing section may be configured remotely. The measurement application server may e.g., provide the user with a user interface to access or configure the analog signal processing section.

The measurement application server may then provide respective configuration data to the portable measurement application device. The portable device communication interface may receive such configuration data, and provide the configuration data to the respective elements of the analog signal processing section.

Although not explicitly mentioned, the above-mentioned optional processor in the portable measurement application device may receive the configuration data, and configure the elements of the analog signal processing section accordingly.

The communication between the portable measurement application device, and the measurement application server may be performed via any type of data connection, like a direct or indirect network connection. In such embodiments, multiple communication networks, like a local communication network at the premises of the user that uses the portable measurement application device, a public network, like the internet, and a local network at the premises of the measurement application server may be present. Further, encryption and overlay networks, like a virtual private network, may also be used.

In such an implementation, the transmission of measurement data to the measurement application server may be slower than the transmission of the digital measurement signal to a data acquisition section of a traditional measurement application device, like an oscilloscope.

In order to compensate for slow data transmissions, the portable device communication interface may comprise a temporary memory for storing the digital measurement signal for transmission via the portable device communication interface to the server communication interface. Such a temporary memory may be provided e.g., in the form of a RAM memory. The temporary memory may be provided as dedicated element, or may be provided as element of the portable device communication interface.

Further, the measurement application server may in such embodiments also comprise a temporary memory or cache for storing the digital measurement signal for processing in the data acquisition unit, and the triggering unit.

In an embodiment, which can be combined with all other embodiments of the portable measurement application device mentioned above or below, the portable device communication interface may at least one of comprise a low latency interface, and be configured to communicate via a low latency protocol.

In order to reduce the delay introduced by slow network connections, the portable device communication interface, and optionally the respective counterpart in the measurement application server, may comprise a low latency interface, like an Ultra-Reliable Low-Latency Communication (uRLLC) wireless interface.

The measurement application server may be provided, as explained above, e.g., as cloud server. Such a cloud server will usually be provided in a data center. The data center may, consequently, be equipped with a low latency interface, and with a connection between the cloud server, and the low latency interface.

The low latency interface may e.g., be implemented with a 5G or 6G modem.

In addition, or as alternative, the portable device communication interface may implement a low latency protocol for data transmission. The low latency protocol may be implemented at least between the portable device communication interface, and the next communication device in the signal chain e.g., a gateway with a low latency connection to the measurement application server. The low latency protocol may also be implemented on the full signal path between the portable device communication interface, and the server communication interface. In such embodiments, the measurement application server is configured to support the respective low latency protocol.

In an embodiment, which can be combined with all other embodiments of the measurement application server mentioned above or below, the measurement application server may further comprise a remotely accessible user interface coupled to at least one of the server communication interface, and the data acquisition unit, wherein the remotely accessible user interface is configured to at least one of display the received at least one digital measurement signal, and display the stored at least one digital measurement signal.

As indicated above, the portable measurement application device does not necessarily comprise a user interface for viewing and manipulating the acquired measurement data.

Therefore, the measurement application server may comprise a user interface, especially a remotely accessible user interface.

Such a remotely accessible user interface may be provided in the form of a website or webpage that may be served by the measurement application server. On a user computer, a browser application may display the remotely accessible user interface. In other embodiments, a native application may be provided that may be executed on a user device to implement the user interface.

The remotely accessible user interface may offer a user similar options as a display of a fully equipped traditional measurement application device, like an oscilloscope. The remotely accessible user interface may e.g., show the received digital measurement signal to the user. The remotely accessible user interface may also show the digital measurement signal as stored by the data acquisition unit.

As already indicated above, the remotely accessible user interface may also provide the user with means for configuring the portable measurement application device.

The remotely accessible user interface may also provide the user with means for configuring the measurement application server, especially at least one of the triggering unit, and the data acquisition unit.

In an embodiment, which can be combined with all other embodiments of the measurement application server mentioned above or below, the measurement application server may further comprise a data storage coupled to at least one of the server communication interface, and the data acquisition unit, wherein the data storage may be configured to at least one of store the received at least one digital measurement signal, and store at least one digital measurement signal for the data acquisition unit based on the triggering events.

The data storage may store not only data that is stored by the data acquisition unit based on the triggering events. The data storage may also serve as a long-term data storage for the full digital measurement signal as received from the portable measurement application device.

The data storage may be integrated into the measurement application server. In embodiments, the data storage may also be provided as external e.g., network attached, storage that is communicatively coupled to the measurement application server.

In an embodiment, which can be combined with all other embodiments of the measurement application server mentioned above or below, the measurement application server may further comprise a processing unit coupled to at least one of the server communication interface, and the data acquisition unit, and when present the data storage, wherein the processing unit may be configured to process the at least one digital measurement signal.

The processing unit may be configured to apply any possible signal processing function to the digital measurement signal. Such processing functions may comprise, but are not limited to, filtering functions, transformation functions, and correlation functions.

The processing unit may also offer a user to apply user-implemented functions to the digital measurement signal. Such user-implemented functions may e.g., be provided by the user as program code e.g., python code, or JavaScript code via the user interface. The user interface may also offer the user a block-based or so called no-code user interface for generating the functions.

In an embodiment, which can be combined with all other embodiments of the measurement application mentioned above or below, the measurement application may further comprise a caching server, the caching server comprising a caching server communication interface configured to receive at least one digital measurement signal from at least one portable measurement application device, a data storage memory coupled to the caching server communication interface, wherein the data storage memory is configured to store the received at least one digital measurement signal, and a data output interface coupled to the data storage memory, wherein the data output interface is configured to output the stored at least one digital measurement signal to the measurement application server.

The caching server may implement an intermediary data storage, and may e.g., be located on the premises of the user of the portable measurement application device.

With the caching server, the portable measurement application device does not need a large internal cache or memory, and a reliable data communication between the portable measurement application device, and the caching server may easily be provided within a local network.

Further, a single caching server may be provided for multiple portable measurement application devices.

In an embodiment, which can be combined with all other embodiments of the measurement application mentioned above or below, the caching server may further comprise a triggering unit coupled to the caching server communication interface, wherein the triggering unit is configured to detect triggering events in the received at least one digital measurement signal, wherein the data output interface may be configured to transmit the at least one digital measurement signal based on the triggering events detected by the triggering unit.

The caching server may be provided with a local triggering unit, and the data output interface of the caching server may output the digital measurement signal to the measurement application server based on detected triggering events. The data output interface may in embodiments output the parts of the digital measurement signal that the data acquisition unit in the measurement application server would have stored.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a portable measurement application device according to the present disclosure;
Figure 2 shows a block diagram of another embodiment of a portable measurement application device according to the present disclosure;
Figure 3 shows a block diagram of another embodiment of a portable measurement application device according to the present disclosure;
Figure 4 shows a block diagram of an embodiment of a measurement application server according to the present disclosure;
Figure 5 shows a block diagram of another embodiment of a measurement application server according to the present disclosure;
Figure 6 shows a block diagram of another embodiment of a measurement application server according to the present disclosure;
Figure 7 shows a block diagram of an embodiment of a measurement application according to the present disclosure;
Figure 8 shows a flow diagram of an embodiment of a method according to the present disclosure;
Figure 9 shows a block diagram of another embodiment of a measurement application according to the present disclosure; and
Figure 10 shows a block diagram of another embodiment of a measurement application according to the present disclosure.

In the figures like reference signs denote like elements unless stated otherwise.

### DETAILED DESCRIPTION OF THE DRAWINGS

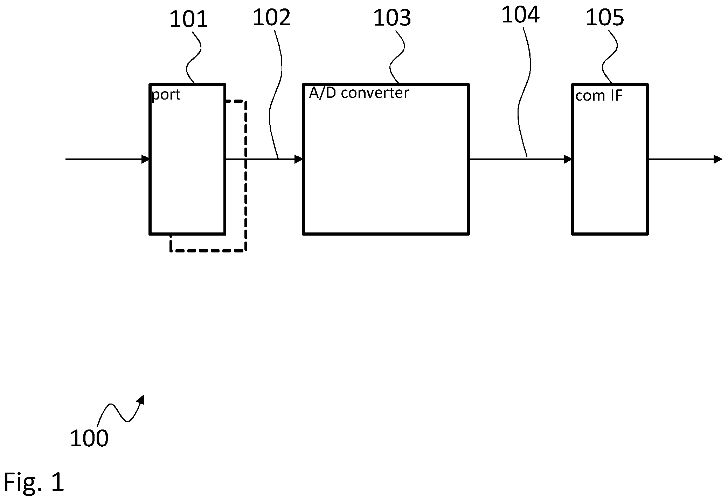

Figure 1 shows a portable measurement application device 100. The portable measurement application device 100 comprises a measurement port 101 that is coupled to an analog-to-digital converter 103. The analog-to-digital converter 103 is coupled to a portable device communication interface 105. The explanations provided in this disclosure regarding any other embodiment of the portable measurement application device 100, may be applied to the portable measurement application device 100 mutatis mutandis.

The measurement port 101 serves for acquiring an analog measurement signal 102. That is provided to the analog-to-digital converter 103 for converting the analog measurement signal 102 into a digital measurement signal 104.

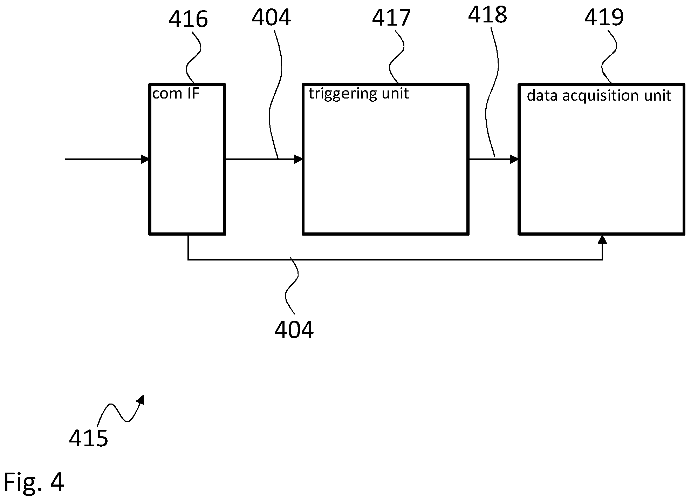

The digital measurement signal 104 is then transmitted via the portable device communication interface 105 to a measurement application server like e.g., shown in figure 4.

The portable measurement application device 100 only comprises a single measurement port 101. However, further possible measurement ports are hinted at by an underlying dashed box. It is understood, that any number of measurement ports is possible.

A single or dedicated analog-to-digital converter 103 may be provided for every measurement port 101. In embodiments, a multi-channel analog-to-digital converter may be provided for multiple measurement ports 101.

The portable device communication interface 105 may comprise any type of wired or wireless data interface, as already explained above. Such a data interface may comprise respective communication controllers, analog interfacing circuitry for interfacing to the physical layer of the data communication channel, and a digital data interface for interfacing to the analog-to-digital converter 103.

Although not explicitly shown, the portable measurement application device 100 may comprise at least one of a controller and a user interface. The controller may serve to control at least the analog-to-digital converter 103, and the portable device communication interface 105. Further, the measurement port 101 may comprise configuration options, like an amplification factor, or an attenuation, without being limited to these examples, that may also be configured via such a controller.

The user interface may serve for a user to directly or indirectly, via the controller, control the elements of the portable measurement application device 100. Such a user interface may e.g., comprise switches, buttons, and knobs. A display is also possible.

A user may e.g., start a measurement via a pushbutton, wherein the analog-to-digital converter 103 will then start converting the analog measurement signal 102 received from the measurement port 101 into a digital measurement signal 104, and forward the digital measurement signal 104 to the portable device communication interface 105. The portable device communication interface 105 will then provide the digital measurement signal 104 to a respective measurement application server.

Although not shown, the portable measurement application device 100 may further comprise a housing, like a hand-held portable housing. Especially with a portable housing, but not limited to this embodiment, the portable measurement application device 100 may also comprise an integrated power supply, like a battery with a respective power supply circuitry. In embodiments, the power supply may be externally provided e.g., via a respective power adapter that may be coupled to the portable measurement application device 100 via a cable.

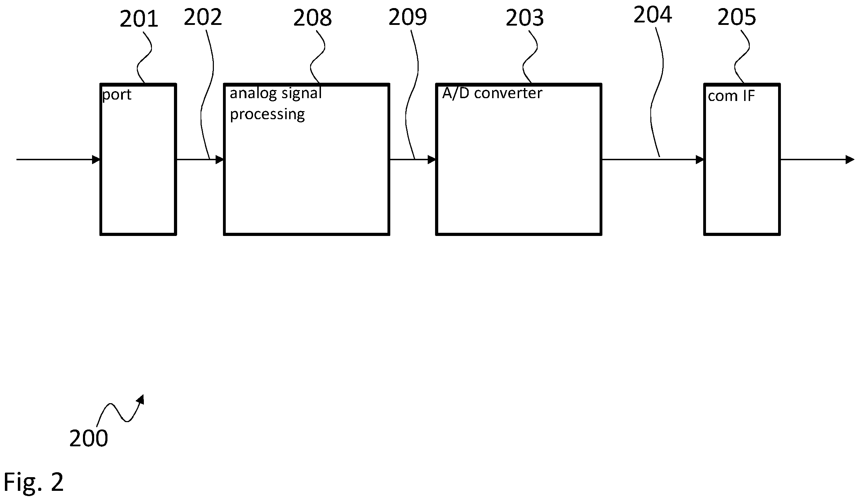

Figure 2 shows a portable measurement application device 200. The portable measurement application device 200 is based on the portable measurement application device 100. The portable measurement application device 200, therefore, comprises a measurement port 201 that is coupled to an analog-to-digital converter 203. The analog-to-digital converter 203 is coupled to a portable device communication interface 205. The explanations provided in this disclosure regarding any other embodiment of the portable measurement application device 200, may be applied to the portable measurement application device 200 mutatis mutandis.

In addition, the portable measurement application device 200 comprises an analog signal processing section 208. The analog signal processing section 208 is arranged between the measurement port 201, and the analog-to-digital converter 203.

The analog signal processing section 208 receives the analog measurement signal 202, and applies or performs an analog signal processing with the analog measurement signal 202 to output the processed analog signal 209 to the analog-to-digital converter 203.

The analog signal processing section 208 may e.g., comprise attenuators, filters, and amplifiers. The analog signal processing section 208 may in embodiments be configurable via the above-mentioned user interface.

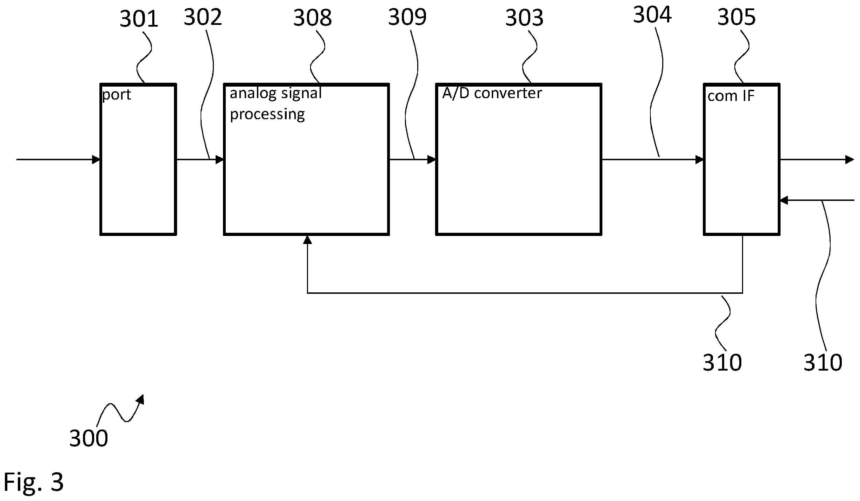

Figure 3 shows a portable measurement application device 300. The portable measurement application device 300 is based on the portable measurement application device 200. The portable measurement application device 300, therefore, comprises a measurement port 301 that is coupled to an analog-to-digital converter 303. The analog-to-digital converter 303 is coupled to a portable device communication interface 305. The portable measurement application device 300 further comprises an analog signal processing section 308 that is arranged between the measurement port 301, and the analog-to-digital converter 303. The explanations provided in this disclosure regarding any other embodiment of the portable measurement application device 300, may be applied to the portable measurement application device 300 mutatis mutandis.

In the portable measurement application device 300, the portable device communication interface 305 is not only configured to transmit the digital measurement signal 304 to a measurement application server. Instead, the portable device communication interface 305 may also receive configuration data 310. The configuration data 310 may be configuration data for configuring the analog signal processing section 308.

Although not explicitly shown, a controller as mentioned above may be provided in the portable measurement application device 300. Such a controller may receive the configuration data 310, and may configure the analog signal processing section 308 accordingly.

In the portable measurement application device 300, the configuration data 310 is shown to be provided for the analog signal processing section 308 only. In embodiments, the configuration data 310 may also be provided for any other element of the portable measurement application device 300. If the above-mentioned controller is present, the configuration data 310 may also comprise data for the controller, like controller configuration data or firmware updates.

Figure 4 shows a measurement application server 415. The measurement application server 415 comprises a server communication interface 416 that is coupled to a triggering unit 417. The measurement application server 415 further comprises a data acquisition unit 419, wherein the triggering unit 417 is also coupled to the data acquisition unit 419. The explanations provided in this disclosure regarding any other embodiment of the measurement application server 415, may be applied to the measurement application server 415 mutatis mutandis.

The server communication interface 416 receives at least one digital measurement signal 404 from one or multiple portable measurement application devices e.g., portable measurement application devices as shown in figures 1 to 3, and provides the received at least one digital measurement signal 404 to the triggering unit 417.

The triggering unit 417 detects triggering events 418 in the received at least one digital measurement signal 404, and forwards information about the detected triggering events 418 to the data acquisition unit 419.

The data acquisition unit 419 stores the at least one digital measurement signal 404 based on the triggering events 418 detected by the triggering unit 417. The data acquisition unit 419 may e.g., store the digital measurement signal 404 for a specific amount of time before, and after a triggering event 418 is detected.

The data acquisition unit 419 may also store the full digital measurement signal 404, and store information about the detected triggering events 418 alongside the digital measurement signal 404. This later allows reconstructing the full measurement easily.

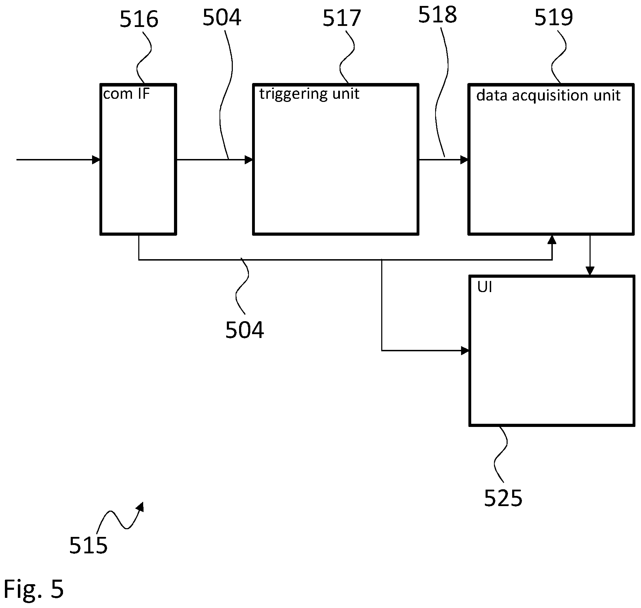

Figure 5 shows a measurement application server 515. The measurement application server 515 is based on the measurement application server 415. The measurement application server 515, therefore, comprises a server communication interface 516 that is coupled to a triggering unit 517, and a data acquisition unit 519, wherein the triggering unit 517 is also coupled to the data acquisition unit 519. The explanations provided in this disclosure regarding any other embodiment of the measurement application server 515, may be applied to the measurement application server 515 mutatis mutandis.

The measurement application server 515 further comprises a user interface 525. The user interface 525 may, especially, be a remotely accessible user interface 525. Such a remotely accessible user interface 525 may e.g., be implemented in the form of a webpage or website that is served by the measurement application server 515 to a user PC, e.g., via the server communication interface 516. In embodiments, an additional communication interface may be provided in the measurement application server 515 to prevent the possibly time-critical communication between a portable measurement application device and the measurement application server 515 from being influenced by the communication with the user PC.

The remotely accessible user interface 525 may be accessed by a user to display the received at least one digital measurement signal 504, and display the stored at least one digital measurement signal 404.

With the remotely accessible user interface 525, the user may operate the setup of the portable measurement application device, and the measurement application server 515, like a normal measurement application device e.g., an oscilloscope.

Although not explicitly mentioned, the remotely accessible user interface 525 may provide all interaction possibilities that a normal measurement application device e.g., an oscilloscope, provides to a user.

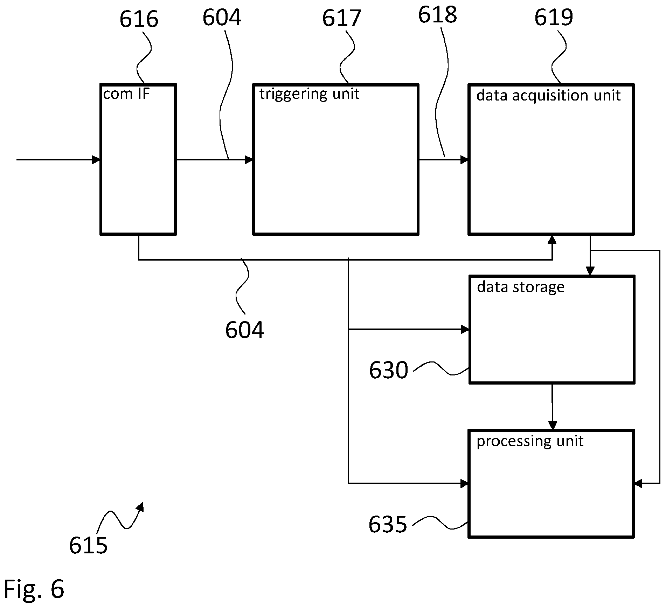

Figure 6 shows a measurement application server 615. The measurement application server 615 is based on the measurement application server 415. The measurement application server 615, therefore, comprises a server communication interface 616 that is coupled to a triggering unit 617, and to a data acquisition unit 619, wherein the triggering unit 617 is also coupled to the data acquisition unit 619. The explanations provided in this disclosure regarding any other embodiment of the measurement application server 615, may be applied to the measurement application server 615 mutatis mutandis.

The measurement application server 615 in addition comprises an optional data storage 630 that may be coupled to at least one of the server communication interface 616, and the data acquisition unit 619. Furter, the measurement application server 615 comprises an optional processing unit 635 that may be coupled to at least one of the server communication interface 616, the data acquisition unit 619, and the data storage 630.

The data storage 630 may store the received at least one digital measurement signal 604, and the digital measurement signal 604 as stored by the data acquisition unit 619 based on the triggering events 618.

The processing unit 635 may process the at least one digital measurement signal 604 either directly, or after storing in the data storage 630. After processing the digital measurement signal 604 as received by the server communication interface 616, the processing unit 635 may store the processed digital measurement signal ion the data storage 630.

The processing unit 635 may e.g., perform any type of processing operations that comprise applying mathematical calculations to the digital measurement signal 604, like converting the digital measurement signal 604 from the time domain to the frequency domain or vice versa, filtering the digital measurement signal 604, and amplifying or attenuating the digital measurement signal 604.

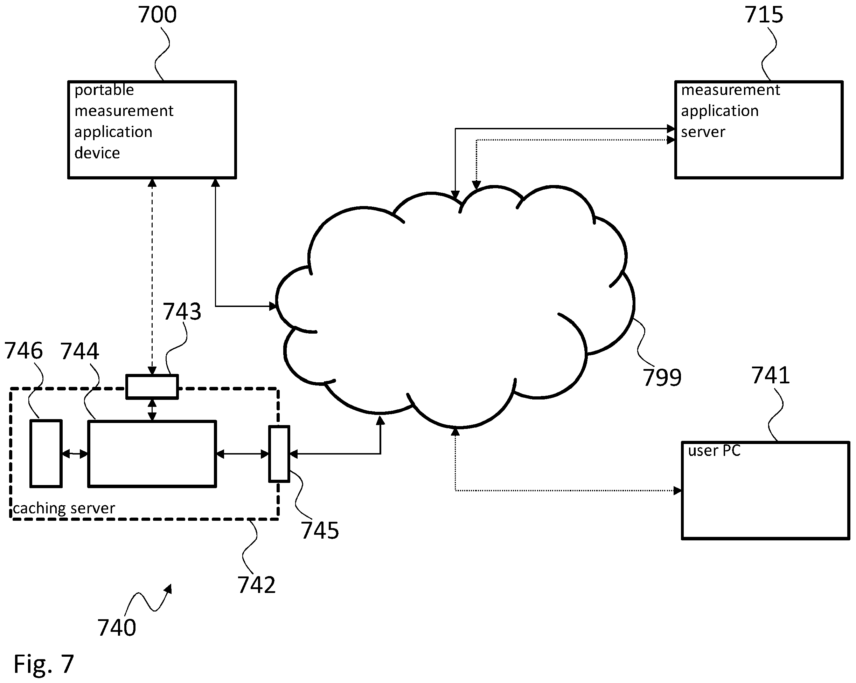

Figure 7 shows a block diagram of an embodiment of a measurement application 740. The measurement application 740 comprises a portable measurement application device 700, a measurement application server 715, and a user PC 741. The portable measurement application device 700, the measurement application server 715, and the user PC 741 are coupled to each other via a public network 799 e.g., the internet. The public network 799 is just provided as an example. In other embodiments, other types of networks, like a wireless 5G/6G data network may be used.

As optional element of the measurement application 740, a caching server 742 is shown. The caching server 742 may be provided locally with the portable measurement application device 700 in the same internal network of a user of the portable measurement application device 700. Instead of directly communicating with the measurement application server 715, the portable measurement application device 700, may then communicate via the caching server 742.

The caching server 742 comprises a caching server communication interface 743 configured to receive at least one digital measurement signal from at least one portable measurement application device 700. The caching server communication interface 743 is coupled to a data storage memory 744, wherein the data storage memory 744 is configured to store the received at least one digital measurement signal at least temporarily, until the at least one digital measurement signal may be transmitted to the measurement application server 715 via the data output interface 745.

The caching server 742 optionally may comprise a triggering unit 746 coupled to at least one of the caching server communication interface 743, and the data storage memory 744. The triggering unit 746 may detect triggering events in the received at least one digital measurement signal like the triggering unit of the measurement application server explained above.

The data output interface 745 may then transmit the at least one digital measurement signal based on the triggering events detected by the triggering unit 746 like the data acquisition unit stores the at least one digital measurement signal based on the triggering events detected by the triggering unit in the measurement application server.

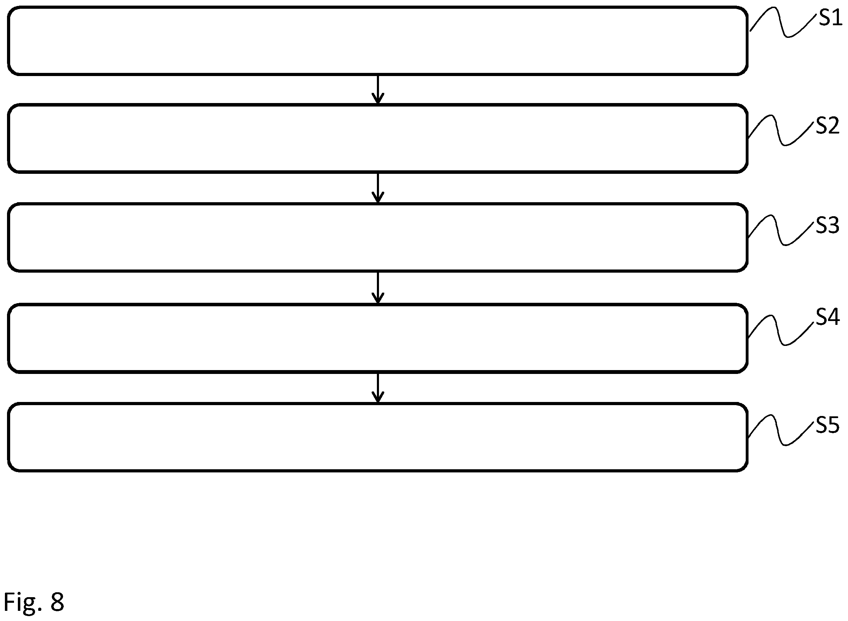

Figure 8 shows a flow diagram of an embodiment of a method for operating a measurement application.

The method comprises acquire S1 at least one analog measurement signal 102, 202, 302 in a portable measurement application device 100, 200, 300, 700, converting S2 the at least one analog measurement signal 102, 202, 302 into at least one respective digital measurement signal 104, 204, 304, 404, 504, 604 in the portable measurement application device 100, 200, 300, 700, outputting S3 the at least one digital measurement signal 104, 204, 304, 404, 504, 604 to a measurement application server 415, 515, 615, 715, detecting S4 triggering events 418, 518, 618 in the at least one digital measurement signal 104, 204, 304, 404, 504, 604 in the measurement application server 415, 515, 615, 715, and storing S5 the at least one digital measurement signal 104, 204, 304, 404, 504, 604 based on the detected triggering events 418, 518, 618 in the measurement application server 415, 515, 615, 715 or a data storage outside of the measurement application server 415, 515, 615, 715.

In embodiments, the method may further comprise processing the at least one analog measurement signal 102, 202, 302 with analog signal processing elements prior to converting the at least one analog measurement signal 102, 202, 302 into a digital measurement signal 104, 204, 304, 404, 504, 604.

Further, the method may comprise applying digital processing functions to the received at least one digital measurement signal 104, 204, 304, 404, 504, 604 in the measurement application server 415, 515, 615, 715 prior or after detecting the triggering events 418, 518, 618.

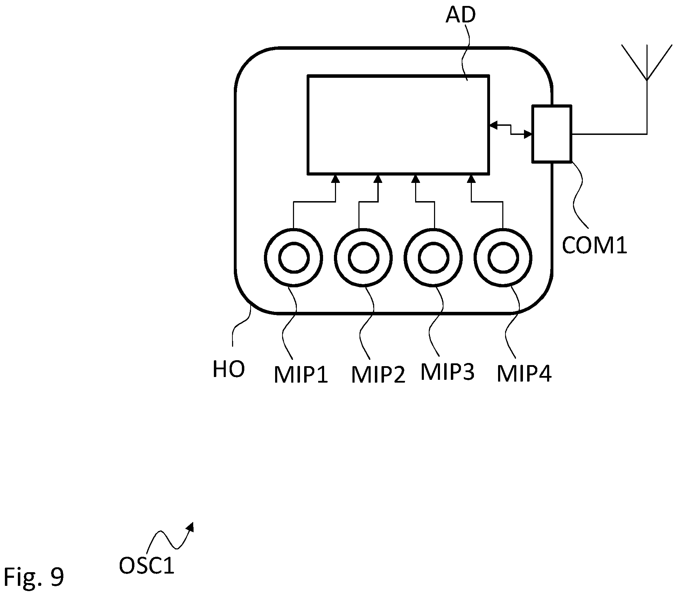

Figure 9 shows a block diagram of an oscilloscope OSC1 that may be used as an embodiment of a portable measurement application device according to the present disclosure.

The oscilloscope OSC1 comprises a housing HO that accommodates four measurement inputs MIP1, MIP2, MIP3, MIP4 that are coupled to an analog-to-digital converter AD for converting the acquired analog measurement signals into digital measurement signals. The analog-to-digital converter AD is coupled to a communication interface COM1 for transmitting the digital measurement signals to a measurement application server according to the present disclosure. Although not explicitly shown, the oscilloscope OSC1 may comprise additional user input elements.

Further, the oscilloscope OSC1 may also comprise signal outputs. Such signal outputs may for example serve to output calibration signals. Such calibration signals allow calibrating the measurement setup prior to performing any measurement. The process of calibrating and correcting any measurement signals based on the calibration may also be called de-embedding and may comprise applying respective algorithms on the measured signals.

Such calibration signals may be provided from the measurement application server to the oscilloscope OSC1 via the communication interface COM1.

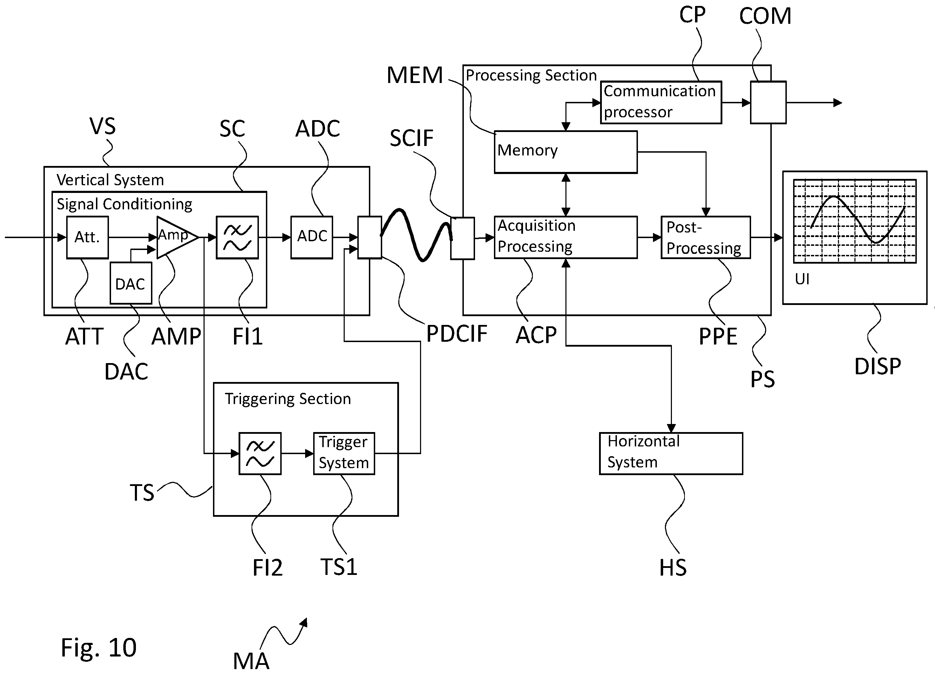

Figure 10 shows a block diagram of a measurement application MA that may comprise an implementation of a portable measurement application device and a measurement application server according to the present disclosure. The measurement application MA may implement the same or similar elements as a digital oscilloscope, but is divided into two main sections.

The measurement application MA exemplarily comprises five general sections. The measurement application MA comprises the vertical system VS that represents the portable measurement application device according to the present disclosure, and that may optionally comprise an analog triggering section TS. The measurement application MA further comprises the horizontal system HS, the processing section PS, and the display DISP that may represent the measurement application server according to the present disclosure. Both sections are coupled to each other via a data communication between the portable device communication interface PDCIF and the server communication interface SCIF.

The vertical system VS mainly serves for acquiring, offsetting, attenuating, and amplifying an analog measurement signal to be acquired. The analog measurement signal may for example be modified to fit in the available space on the display DISP or to comprise a vertical size as configured by a user.

To this end, the vertical system VS comprises a signal conditioning section SC with an attenuator ATT and a digital-to-analog-converter DAC that are coupled to an amplifier AMP. The amplifier AMP is coupled to a filter FI1, which in the shown example is provided as a low pass filter. The vertical system VS also comprises an analog-to-digital converter ADC that receives the output from the filter FI1, and converts the analog signal into a digital signal.

The attenuator ATT and the amplifier AMP serve to scale the amplitude of the signal to be acquired to match the operation range of the analog-to-digital converter ADC. The digital-to-analog-converter DAC1 serves to modify the DC component of the input signal to be acquired to match the operation range of the analog-to-digital converter ADC. The filter FI1 serves to filter out unwanted high frequency components of the signal to be acquired.

The triggering section TS operates on the signal as provided by the amplifier AMP. The triggering section TS comprises a filter FI2, which in this embodiment is implemented as a low pass filter. The filter FI2 is coupled to a trigger system TS1.

The optional triggering section TS serves to capture predefined signal events. The triggering events may then be provided to the horizontal system HS and allow the horizontal system HS to e.g., display a stable view of a repeating waveform, or to simply display waveform sections that comprise the respective signal event in the display DISP. It is understood, that the predefined signal event may be configured by a user via a user input.

Possible predefined signal events may for example include, but are not limited to, when the signal crosses a predefined trigger threshold in a predefined direction i.e., with a rising or falling slope. Such a trigger condition is also called an edge trigger. Another trigger condition is called "glitch triggering" and triggers, when a pulse occurs in the signal to be acquired that has a width that is greater than or less than a predefined amount of time.

In order to allow an exact matching of the trigger event and the waveform that is shown on the display DISP, a common time base may be established for the analog-to-digital converter ADC and the trigger system TS1.

It is understood, that although not explicitly shown, the trigger system TS1 may comprise at least one of configurable voltage comparators for setting the trigger threshold voltage, fixed voltage sources for setting the required slope, respective logic gates like e.g., a XOR gate, and FlipFlops to generate the triggering signal.

The triggering section TS is exemplarily provided as an analog trigger section. It is understood, that the measurement application MA may also be provided with a digital triggering section. Such a digital triggering section will not operate on the analog signal as provided by the amplifier AMP but will operate on the digital signal as provided by the analog-to-digital converter ADC, and will be provided in the processing section PS.

A digital triggering section may comprise a processing element, like a processor, a DSP, a CPLD, an ASIC or an FPGA to implement digital algorithms that detect a valid trigger event.

With the analog trigger section TS, the horizontal system HS receives the output of the trigger system TS1 via the portable device communication interface PDCIF, and the server communication interface SCIF and mainly serves to position and scale the signal to be acquired horizontally on the display DISP.

The measurement application MA further comprises a processing section PS that implements digital signal processing and data storage for the measurement application MA. The processing section PS, and optionally the horizontal system HS, and the user interface, shown here as the display DISP, form the measurement application server in the measurement application MA.

The processing section PS comprises an acquisition processing element ACP that is couple to the output of the analog-to-digital converter ADC and the output of the horizontal system HS as well as to a memory MEM and a post processing element PPE.

The acquisition processing element ACP manages the acquisition of digital data from the analog-to-digital converter ADC and the storage of the data in the memory MEM. The acquisition processing element ACP may for example comprise a processing element with a digital interface to the analog-to-digital converter ADC2 and a digital interface to the memory MEM. The processing element may for example comprise a microcontroller, a DSP, a CPLD, an ASIC or an FPGA with respective interfaces. In a microcontroller or DSP, the functionality of the acquisition processing element ACP may be implemented as computer readable instructions that are executed by a CPU. In a CPLD or FPGA the functionality of the acquisition processing element ACP may be configured in to the CPLD or FPGA opposed to software being executed by a processor.

The processing section PS further comprises a communication processor CP and a communication interface COM.

The communication processor CP may be a device that manages data transfer to and from the measurement application MA. The communication interface COM for any adequate communication standard like for example, Ethernet, WIFI, Bluetooth, NFC, an infra-red communication standard, and a visible-light communication standard.

The communication processor CP is coupled to the memory MEM and may use the memory MEM to store and retrieve data.

Of course, the communication processor CP may also be coupled to any other element of the measurement application MA to retrieve device data or to provide device data that is received from the management server.

The post processing element PPE may be controlled by the acquisition processing element ACP and may access the memory MEM to retrieve data that is to be displayed on the display DISP. The post processing element PPE may condition the data stored in the memory MEM such that the display DISP may show the data e.g., as waveform to a user. The post processing element PPE may also realize analysis functions like cursors, waveform measurements, histograms, or math functions.

The display DISP controls all aspects of signal representation to a user, although not explicitly shown, may comprise any component that is required to receive data to be displayed and control a display device to display the data as required.

It is understood, that even if it is not shown, the measurement application MA may also comprise a user interface for a user to interact with the measurement application MA. Such a user interface may comprise dedicated input elements like for example knobs and switches. At least in part the user interface may also be provided as a touch sensitive display device.

It is understood, that all elements of the measurement application MA that perform digital data processing may be provided as dedicated elements. As alternative, at least some of the above-described functions may be implemented in a single hardware element, like for example a microcontroller, DSP, CPLD or FPGA. Generally, the above-describe logical functions may be implemented in any adequate hardware element of the measurement application MA and not necessarily need to be partitioned into the different sections explained above.

The processes, methods, or algorithms disclosed herein can be delivera-ble to/implemented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software, and firmware components.

While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims, along with the full scope of equivalents to which such claims are entitled. It is anticipated and intended that future developments will occur in the technologies discussed herein, and that the disclosed systems and methods will be incorporated into such future embodiments. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

### LIST OF REFERENCE SIGNS

- 100, 200, 300, 700: portable measurement application device
- 101, 201, 301: measurement port
- 102, 202, 302: analog measurement signal
- 103, 203, 303: analog-to-digital converter
- 104, 204, 304, 404, 504, 604: digital measurement signal
- 105, 205, 305: portable device communication interface

- 208, 308: analog signal processing section
- 209, 309: processed analog signal

- 310: configuration data

- 415, 515, 615, 715: measurement application server
- 416, 516, 616: server communication interface
- 417, 517, 617: triggering unit
- 418, 518, 618: triggering event
- 419, 519, 619: data acquisition unit

- 525: remotely accessible user interface

- 630: data storage
- 635: processing unit

- 740: measurement application
- 741: user PC
- 742: caching server
- 743: caching server communication interface
- 744: data storage memory
- 745: data output interface
- 746: triggering unit

- 799: public network
- S1 - S5: method steps

- OSC1: oscilloscope
- HO: housing
- MIP1, MIP2, MIP3, MIP4: measurement input
- AD: analog-to-digital converter
- COM1: communication interface

- OSC: oscilloscope
- VS: vertical system
- SC: signal conditioning
- ATT: attenuator
- DAC1: analog-to-digital converter
- AMP: amplifier
- FI1: filter
- ADC: analog-to-digital converter
- PDIF: portable device communication interface

- TS: triggering section
- FI2: filter
- TS1: trigger system

- HS: horizontal system

- PS: processing section
- SCIF: server communication interface
- ACP: acquisition processing element
- MEM: memory
- PPE: post processing element
- CP: communication processor
- COM: communication interface

- DISP: display

## Claims

1. Portable measurement application device (100, 200, 300, 700) comprising:
at least one measurement port (101, 201, 301) configured to acquire an analog measurement signal (102, 202, 302);
an analog-to-digital converter (103, 203, 303) for every measurement port (101, 201, 301), wherein the analog-to-digital converter (103, 203, 303) is configured to convert the analog measurement signal (102, 202, 302) acquired by the respective measurement port (101, 201, 301) into a digital measurement signal (104, 204, 304, 404, 504, 604); and
a portable device communication interface (105, 205, 305, PDCIF) coupled to each analog-to-digital converter (103, 203, 303), and configured to output the digital measurement signal (104, 204, 304, 404, 504, 604) of each analog-to-digital converter (103, 203, 303) to a measurement application server (415, 515, 615, 715).

2. Portable measurement application device (100, 200, 300, 700) according to claim 1, further comprising an analog signal processing section (208, 308) for each measurement port (101, 201, 301) that is coupled between the respective measurement port (101, 201, 301) and the respective analog-to-digital converter (103, 203, 303).

3. Portable measurement application device (100, 200, 300, 700) according to claim 2, wherein the portable device communication interface (105, 205, 305, PDCIF) is further configured to receive configuration data (310) from the measurement application server (415, 515, 615, 715), and to forward the configuration data (310) to the analog signal processing section (208, 308) for configuring the analog signal processing section (208, 308).

4. Portable measurement application device (100, 200, 300, 700) according to any one of the preceding claims, wherein the portable device communication interface (105, 205, 305, PDCIF) at least one of comprises a low latency interface, and is configured to communicate via a low latency protocol.

5. Measurement application server (415, 515, 615, 715) comprising:
a server communication interface (416, 516, 616, SCIF) configured to receive at least one digital measurement signal (104, 204, 304, 404, 504, 604) from at least one portable measurement application device (100, 200, 300, 700);
a triggering unit (417, 517, 617) coupled to the server communication interface (416, 516, 616, SCIF), wherein the triggering unit (417, 517, 617) is configured to detect triggering events (418, 518, 618) in the received at least one digital measurement signal (104, 204, 304, 404, 504, 604); and
a data acquisition unit (419, 519, 619) coupled to the server communication interface (416, 516, 616, SCIF), and to the triggering unit (417, 517, 617), wherein the data acquisition unit (419, 519, 619) is configured to store the at least one digital measurement signal (104, 204, 304, 404, 504, 604) based on the triggering events (418, 518, 618) detected by the triggering unit (417, 517, 617).

6. Measurement application server (415, 515, 615, 715) according to claim 5, further comprising:
a remotely accessible user interface (525) coupled to at least one of the server communication interface (416, 516, 616, SCIF), and the data acquisition unit (419, 519, 619);
wherein the remotely accessible user interface (525) is configured to at least one of display the received at least one digital measurement signal (104, 204, 304, 404, 504, 604), and display the stored at least one digital measurement signal (104, 204, 304, 404, 504, 604).

7. Measurement application server (415, 515, 615, 715) according to any of the preceding claims 5 and 6, further comprising:
a data storage (630) coupled to at least one of the server communication interface (416, 516, 616, SCIF), and the data acquisition unit (419, 519, 619);
wherein the data storage (630) is configured to at least one of store the received at least one digital measurement signal (104, 204, 304, 404, 504, 604), and store at least one digital measurement signal (104, 204, 304, 404, 504, 604) for the data acquisition unit (419, 519, 619) based on the triggering events (418, 518, 618).

8. Measurement application server (415, 515, 615, 715) according to any of the preceding claims 5 to 7, further comprising:
a processing unit (635) coupled to at least one of the server communication interface (416, 516, 616, SCIF), and the data acquisition unit (419, 519, 619), and when depending on claim 7 the data storage (630); and
wherein the processing unit (635) is configured to process the at least one digital measurement signal (104, 204, 304, 404, 504, 604).

9. Measurement application (740) comprising:
at least one portable measurement application device (100, 200, 300, 700) according to any one of claims 1 to 4; and
a measurement application server (415, 515, 615, 715) according to any one of the preceding claims 5 to 8.

10. Measurement application (740) according to claim 9, further comprising:
a caching server (742), the caching server (742) comprising:
a caching server communication interface (743) configured to receive at least one digital measurement signal (104, 204, 304, 404, 504, 604) from at least one portable measurement application device (100, 200, 300, 700);
a data storage memory (744) coupled to the caching server communication interface (743), wherein the data storage memory (744) is configured to store the received at least one digital measurement signal (104, 204, 304, 404, 504, 604); and
a data output interface (745) coupled to the data storage memory (744), wherein the data output interface (745) is configured to output the stored at least one digital measurement signal (104, 204, 304, 404, 504, 604) to the measurement application server (415, 515, 615, 715).

11. Measurement application (740) according to claim 10, wherein the caching server (740) further comprises:
a triggering unit (746) coupled to the caching server communication interface (743), wherein the triggering unit (746) is configured to detect triggering events (418, 518, 618) in the received at least one digital measurement signal (104, 204, 304, 404, 504, 604); and
wherein the data output interface (745) is configured to transmit the at least one digital measurement signal (104, 204, 304, 404, 504, 604) based on the triggering events (418, 518, 618) detected by the triggering unit (746).

12. Method for operating a measurement application, the method comprising:
acquire (S1) at least one analog measurement signal (102, 202, 302) in a portable measurement application device (100, 200, 300, 700);
converting (S2) the at least one analog measurement signal (102, 202, 302) into at least one respective digital measurement signal (104, 204, 304, 404, 504, 604) in the portable measurement application device (100, 200, 300, 700),
outputting (S3) the at least one digital measurement signal (104, 204, 304, 404, 504, 604) to a measurement application server (415, 515, 615, 715);
detecting (S4) triggering events (418, 518, 618) in the at least one digital measurement signal (104, 204, 304, 404, 504, 604) in the measurement application server (415, 515, 615, 715); and
storing (S5) the at least one digital measurement signal (104, 204, 304, 404, 504, 604) based on the detected triggering events (418, 518, 618) in the measurement application server (415, 515, 615, 715) or a data storage outside of the measurement application server (415, 515, 615, 715).

13. Method according to claim 12, further comprising processing the at least one analog measurement signal (102, 202, 302) with an analog signal processing section (208, 308) prior to converting the at least one analog measurement signal (102, 202, 302) into a digital measurement signal (104, 204, 304, 404, 504, 604).

14. Method according to any of the preceding claims 12 and 13, further comprising:
applying digital processing functions to the received at least one digital measurement signal (104, 204, 304, 404, 504, 604) in the measurement application server (415, 515, 615, 715) prior or after detecting the triggering events (418, 518, 618).

15. Computer program product comprising computer readable instructions that when executed by a processor cause the processor to perform the function of the measurement application server (415, 515, 615, 715) according to any one of claims 5 to 9, or the method according to any of the preceding claims 12 to 14.
